# EUROPEAN PATENT SPECIFICATION

(11) **EP 0 374 782 B1**
(45) Date of publication and mention of the grant of the patent: **22.02.1995**
(21) Application number: 89123329.8
(22) Date of filing: 16.12.1989
(51) Int. Cl.: G05F 3/20, G11C 5/14, G05F 1/46

(54) **BICMOS positive supply voltage reference**
BICMOS positive Spannungsreferenzversorgung
Alimentation de référence de tension positive BICMOS

(30) Priority: 21.12.1988 US 287967
(43) Date of publication of application: 27.06.1990
(73) Proprietor: NATIONAL SEMICONDUCTOR CORPORATION, Santa Clara California 95051-8090 (US)
(72) Inventor: Smith, Douglas D., Puyallup, WA 98373 (US); Bowman, Terrance L., Sumner, WA 98390 (US)
(74) Representative: Sparing Röhl Henseler Patentanwälte

(56) References cited:
- EP-A- 0 113 865
- US-A- 4 267 501
- US-A- 4 675 557
- IBM TECHNICAL DISCLOSURE BULLETIN, vol. 31, no. 12, May 1989, pages 192-194,Armonk, NY, US; "Regulated on-chip voltage converter"

## Description

The present invention relates to BICMOS voltage reference circuits, and in particular to such reference circuits for EPROMs.

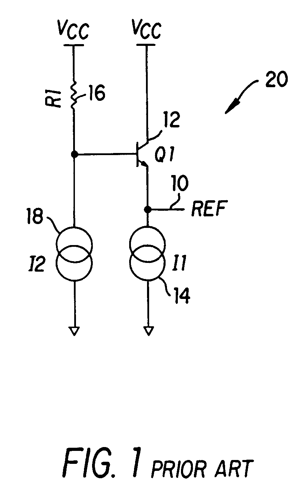

A typical prior art positive voltage reference is shown in Fig. 1. The voltage reference is provided on a line 10 from a bipolar transistor 12 which is coupled to a positive voltage supply VCC. A current source 14 provides the necessary current. Transistor 12 is biased by a resistor 16 coupled to voltage supply VCC. A second current source 18 provides the appropriate current to the base of transistor 12 to provide the appropriate voltage level at reference line 10.

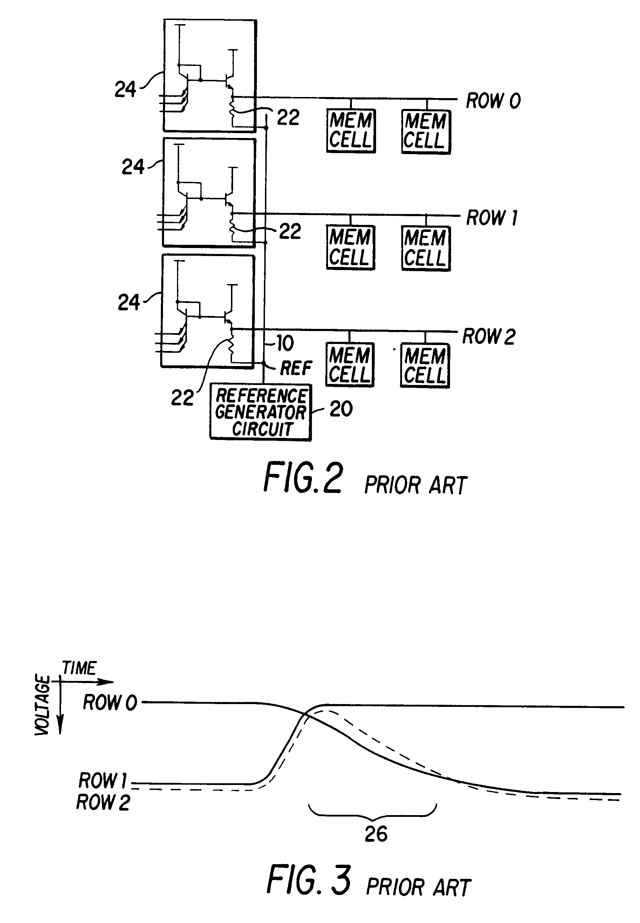

Fig. 2 shows a typical use for such a reference generator circuit 20 for an ECL memory. Reference line 10 is connected through resistors 22 in row decode circuits 24 to row lines 0, 1 and 2, respectively. As can be seen, with a large number of row lines connected, the circuit of Fig. 1 will reach the maximum amount of current of current source 14 and thus pull down the voltage at reference line 10. This phenomena is shown in Fig. 3 during a switching period 26 in which a row line 1 goes high but a row line 0 has not yet discharged, causing the reference line to give a false indication of a high value on row line 2. If the current source 14 in Fig. 1 is split among enough row lines, the amount of current to each row line will decrease, thus lowering the voltage level. Without sufficient current to quickly discharge a deselected row, the speed of the address access is slowed.

One solution is to add a discharge circuit to discharge the capacitance of a row line and thus limit the amount of current required from the voltage reference circuit. However, this adds a considerable amount of circuitry since a separate discharge circuit is required for each row line. Such a discharge circuit is shown on page 108-109 of the 1983 IEEE International Solid-State Circuits Conference Digest of Technical Papers.

The present invention is defined by claim 1. The combination of features set forth in its preamble are known from EP-A-0,113,865.

The present invention provides a voltage reference level using a bipolar output transistor to provide a reference voltage on a reference output line. A control circuit is used for varying the current to the base of the output transistor in response to the load on the reference output line. In addition, the control circuit provides the reference levels to the output transistor. The MOS control circuit and the bipolar output transistor are fabricated on the same chip using a BICMOS process. The voltage reference provided by the control circuit is derived from a voltage level provided by a resistor coupled between the positive voltage supply and a current source.

In a preferred embodiment, the control circuit consists of MOS transistors arranged to control the output transistor base current in response to the output current of the reference circuit and to simultaneously hold the reference line output at the reference voltage level. In one embodiment, a PMOS transistor has its source and drain coupled between the reference output and the base of the output transistor. Thus, the base current of the output transistor is coupled to the reference output to provide tracking. A second embodiment uses a current mirror configuration.

A capacitor is coupled between the voltage supply and the reference line output to counteract oscillation. A resistor is coupled to the base of the output bipolar transistor to provide biasing.

For a further understanding of the objects and advantages of the invention, reference should be made to the ensuing description taken in conjunction with the accompanying drawings.
Fig. 1 is a circuit diagram of a prior art voltage reference;
Fig. 2 is a block diagram of a prior art ECL memory array using a reference generator circuit;
Fig. 3 is a diagram showing the voltage effects of the selection of multiple rows on a voltage reference circuit according to the prior art;
Fig. 4 is a diagram of a reference circuit according to the present invention;
Fig. 5 is a diagram of first embodiment of the reference circuit of Fig. 4; and
Fig. 6 is a diagram of a second embodiment of the reference circuit of Fig. 4.

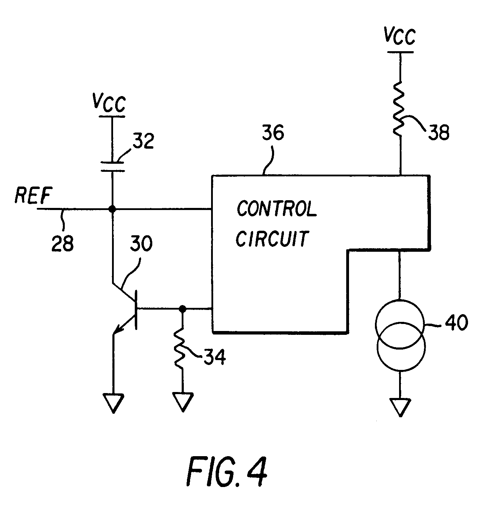

Fig. 4 shows a voltage reference circuit according to the present invention. An output reference line 28 is coupled to the collector of a bipolar output transistor 30. The collector of transistor 30 is coupled through a capacitor 32 to positive voltage supply VCC. The base of transistor 30 is coupled by a resistor 34 to a ground reference level. A control circuit 36 is connected to the collector and base of transistor 30 and connects reference line 28 to a voltage reference level setting circuit which includes a resistor 38 and a current source 40.

Control circuit 36 not only supplies the voltage reference from resistor 38 and current source 40 to reference line 28, but also controls the current to the base of transistor 30 in response to the load on line 28. Resistor 34 is used to bias transistor 30 to the proper operating level. Capacitor 32 is added in order to counteract the possibility of oscillation.

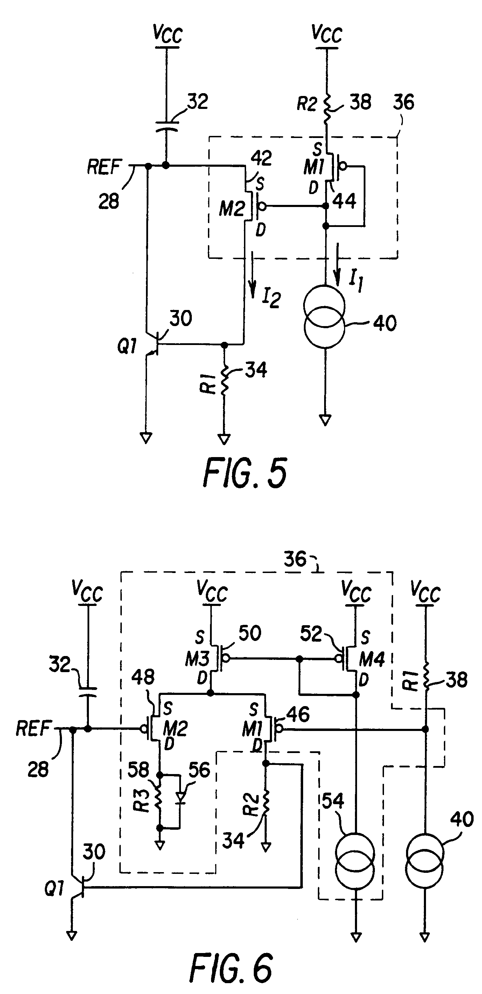

Fig. 5 shows a first embodiment of the control circuit 36 of Fig. 4. As can be seen, control circuit 36 includes transistors 42 and 44. Resistor 38 generates the required voltage level that is needed and is referenced to the positive supply VCC. A PMOS transistor 44 generates the proper gate voltage for PMOS transistor 42 to ensure that the source of transistor 42 will be equal to the required reference voltage. Transistor 42 also sets the DC operating current and supplies the base current to bipolar transistor 30 during transient mode high current operation. Transistors 44 and 42 form a current mirror to drive the base of transistor 30. Thus, the current I₁ in current source 40 is reflected as current I₂ into the base of transistor 30. The value of resistor 34 is chosen to provide conduction by transistor 30 at the desired level.

If the voltage on line 28 rises due to an increased load, more current is supplied through PMOS transistor 42 to the base of transistor 30 which in turn will try to pull the reference voltage on line 28 back down. If the reference voltage on line 28 decreases in voltage, less current flows through PMOS transistor 42, decreasing the base current into transistor 30, which allows the voltage reference level to rise. The DC current flowing through transistor 42 and resistor 34 biases transistor 30 at its proper operation level. The design of Fig. 5 has the advantage of a low DC operating current with a very high transient mode capability. Thus, little current is used in a steady state operation, but a large amount of current can be supplied for switching voltage levels.

Fig. 6 shows an alternate version of the circuit of Fig. 4. Again, resistor 38 generates the voltage reference, which is presented to the gate of PMOS transistor 46. Transistor 46 is coupled to another PMOS transistor 48, which has a gate which will try to equal the gate of transistor 46. Current is supplied to transistors 46 and 48 by a transistor 50, which is one leg of a current mirror consisting of transistors 50 and 52. The other leg of the current mirror includes a current source 54. Transistors 46 and 48 form a differential amplifier which drives the base of transistor 30. The differential amplifier combined with the gain of transistor 30 will force the gate of transistor 48 to the reference level. If the reference voltage on line 28 raises, less current will flow through transistor 48, and more current will flow through transistor 46 to the base of transistor 30, which will in turn try to pull the voltage reference level on line 28 down.

To equalize the load at the drain of transistors 46 and 48, a diode 56 is added between the drain of transistor 48 and the negative voltage reference to correspond to the diode drop of the base-emitter junction of transistor 30, which is in parallel with resistor 34. A resistor 58 is added in parallel with diode 56 to correspond to resistor 34. Transistors 46 and 48 are long channel length devices in order to give a constant current reference level for a varying drain to source voltage level. This is possible because a long channel length results in the gate to source voltage (Vgs) leveling off to become relatively constant as the drain current increases or the drain to source voltage varies. The embodiment of Fig. 6 has a higher DC operating current than the embodiment of Fig. 5, but the reference voltage is more accurate.

As will be evident to those of skill in the art, the present invention can be embodied in other specific forms without departing from the spirit or essential characteristics thereof. For example, a different circuit could be used to bias transistor 30, bipolar transistor 30 could be an NMOS transistor, or resistor 38 could be replaced with a diode. Accordingly, the disclosure of the preferred embodiments of the invention is to be illustrative, but not limiting, of the scope of the invention which is set forth in the following claims.

## Claims

1. A reference circuit for producing a first reference voltage level (REF) from a positive voltage supply (V_{cc}) the reference circuit having:
an output transistor (30) which has a control electrode and an output electrode for providing said first reference voltage level at an output (28);
voltage level means (38, 40), coupled to said positive voltage supply (V_{cc}), for establishing a second reference voltage level, characterized in that:
said voltage level means (38, 40) includes control circuit means (36), coupled to said output (28) and to the control electrode of said output transistor (30) for providing at said output (28) said first reference voltage level (REF) from said second reference voltage level whereby the current to said control electrode increases in response to an increase in said first reference voltage level (REF) and the current to said control electrode decreases in response to a decrease in said first reference voltage level (REF).

2. The reference circuit of claim 1 wherein said voltage level means comprises:
a first resistor (38) coupled to said positive voltage supply; and
a first current (40) source coupled to said resistor to produce a first voltage level at a node between said first resistor and said first current source.

3. The reference circuit of claim 1 wherein said output transistor (30) is a bipolar transistor.

4. The circuit of claim 1 further comprising a capacitor (32) coupling said output electrode to said positive voltage supply.

5. The circuit of claim 1 further comprising a biasing resistor (34) coupling the control electrode of said output transistor to a voltage reference negative with respect to said positive voltage supply.

6. The circuit of claims 2 and 3 wherein said control circuit means comprises:
a first MOS transistor (44) having a first output electrode coupled to said first resistor (38), a second output electrode coupled to said first current source (40) and a gate coupled to said node; and
a second MOS transistor (42) having a first output electrode coupled to said reference circuit output (28), a second output electrode coupled to said base of said bipolar transistor (30) and a gate coupled to said gate of said first MOS transistor.

7. The circuit of claim 6 wherein said MOS transistors are PMOS transistors.

8. The circuit of claim 1 wherein said control circuit means comprises a differential pair of first (46) and second (48) MOS transistors, said first MOS transistor having a gate coupled to said voltage level means and a first output electrode coupled to said base of said bipolar transistor (30), said second MOS transistor having a gate coupled to said reference circuit output (28).

9. The circuit of claim 8 further comprising a current mirror circuit (50, 52) having a first leg coupled to second output electrodes of said first and second MOS transistors and a second leg coupled to a second current source (54).

## Patentansprüche

1. Eine Referenzschaltung für das Erzeugen eines ersten Referenzspannungspegels (REF) aus einer positiven Spannungsversorgung (V_{cc}), welche Referenzschaltung aufweist:
einen Ausgangstransistor (30) mit einer Steuerelektrode und einer Ausgangselektrode für das Bereitstellen des ersten Referenzspannungspegels an einem Ausgang (28);
Spannungspegelmittel (38, 40), angekoppelt an die positive Spannungsversorgung (V_{cc}) für das Etablieren eines zweiten Referenzspannungspegels, dadurch gekennzeichnet, daß die Spannungspegelmittel (38, 40) Steuerschaltungsmittel (36) umfassen, angekoppelt an den Ausgang (28) und an die Steuerelektrode des Ausgangstransistors (30) für das Bereitstellen des ersten Referenzspannungspegels (REF) von dem zweiten Referenzspannungspegel an dem Ausgang (28), wodurch der Strom zu der Steuerelektrode zunimmt in Reaktion auf eine Zunahme des ersten Referenzspannungspegels (REF) und der Strom zu der Steuerelektrode abnimmt in Reaktion auf eine Abnahme des ersten Referenzspannungspegels (REF).

2. Die Referenzschaltung nach Anspruch 1, bei der das Spannungspegelmittel umfaßt:
einen ersten Widerstand (38), angekoppelt an die positive Spannungsversorgung, und
eine erste Stromquelle (40), angekoppelt an den Widerstand zum Erzeugen eines ersten Spannungspegels an einem Knoten zwischen dem ersten Widerstand und der ersten Stromquelle.

3. Die Referenzschaltung nach Anspruch 1, bei der der Ausgangstransistor (30) ein Bipolartransistor ist.

4. Die Schaltung nach Anspruch 1, ferner umfassend einen Kondensator (32), der die Ausgangselektrode an die positive Spannungsversorgung koppelt.

5. Die Schaltung nach Anspruch 1, ferner umfassend einen Vorspannwiderstand (34), der die Steuerelektrode des Ausgangstransistors mit einer Spannungsreferenz koppelt, die negativ ist relativ zu der positiven Spannungsversorgung.

6. Die Schaltung nach Anspruch 2 und 3, bei der das Steuerschaltungsmittel umfaßt:
einen ersten MOS-Transistor (44) mit einer ersten Ausgangselektrode an den ersten Widerstand (38) angekoppelt, mit einer zweiten Ausgangselektrode an die erste Stromquelle (40) angekoppelt, und mit einem Gate, das an den Knoten angekoppelt ist, und
einen zweiten MOS-Transistor (42) mit einer ersten Ausgangselektrode an den Referenzschaltungsausgang (28) angekoppelt, einer zweiten Ausgangselektrode an die Basis des Bipolartransistors (30) angekoppelt, und mit einem Gate, das mit dem Gate des ersten MOS-Transistors gekoppelt ist.

7. Die Schaltung nach Anspruch 6, bei der die MOS-Transistoren PMOS-Transistoren sind.

8. Die Schaltung nach Anspruch 1, bei der die Steuerschaltungsmittel ein Differentialpaar eines ersten (46) und zweiten (48) MOS-Tranistors umfassen, wobei der erste MOS-Transistor mit einem Gate an das Spannungspegelmittel angekoppelt ist und mit einer ersten Ausgangselektrode an die Basis des Bipolartransistors (30), während der zweite MOS-Transistor mit einem Gate an den Referenzschaltungsausgang (28) angekoppelt ist.

9. Die Schaltung nach Anspruch 8, ferner umfassend eine Stromspiegelschaltung (50, 52), deren einer Schenkel mit zweiten Ausgangselektroden des ersten und des zweiten MOS-Transistors gekoppelt ist und dessen zweiter Schenkel mit einer zweiten Stromquelle (54) gekoppelt ist.

## Revendications

1. Circuit de référence pour produire un premier niveau de tension de référence (REF) à partir d'une alimentation en tension positive (V_{cc}), le circuit de référence comprenant :
un transistor de sortie (30) qui présente une électrode de commande et une électrode de sortie pour fournir ledit premier niveau de tension de référence sur une sortie (28);
des moyens de niveau de tension (38,40), connectés à ladite alimentation en tension positive (V_{cc}), pour établir un deuxième niveau de tension de référence, caractérisé en ce que :
lesdits moyens de niveau de tension (38,40) comprennent des moyens de circuit de commande (36), connectés à ladite sortie (28) et à ladite électrode de commande dudit transistor de sortie (30) pour fournir sur ladite sortie (28) ledit premier niveau de tension de référence (REF) à partir dudit deuxième niveau de tension de référence, le courant dans ladite électrode de commande augmentant en réponse à une augmentation dudit premier niveau de tension de référence (REF) et le courant dans ladite électrode de commande diminuant en réponse à une diminution dudit premier niveau de tension de référence (REF).

2. Circuit de référence selon la revendication 1 dans lequel lesdits moyens de niveau de tension comprennent :
une première résistance (38) connectée à ladite alimentation en tension positive; et
une première source de courant (40) connectée à ladite résistance pour produire un premier niveau de tension sur un noeud entre ladite première résistance et ladite première source de courant.

3. Circuit de référence selon la revendication 1 dans lequel ledit transistor de sortie (30) est un transistor bipolaire.

4. Circuit selon la revendication 1 comprenant en outre un condensateur (32) connectant ladite électrode de sortie à ladite alimentation en tension positive.

5. Circuit selon la revendication 1 comprenant en outre une résistance de polarisation (34) connectant l'électrode de commande dudit transistor de sortie à une référence de tension négative par rapport à ladite alimentation en tension positive.

6. Circuit selon les revendications 2 et 3 dans lequel lesdits moyens de circuit de commande comprennent :
un premier transistor MOS (44) ayant une première électrode de sortie connectée à ladite première résistance (38), une deuxième électrode de sortie connectée à ladite première source de courant (40) et une grille connectée audit noeud; et
un deuxième transistor MOS (42) ayant une première électrode de sortie connectée à ladite sortie du circuit de référence (28), une deuxième électrode de sortie connectée à ladite base dudit transistor bipolaire (30) et une grille connectée à ladite grille dudit premier transistor MOS.

7. Circuit selon la revendication 6 dans lequel lesdits transistors MOS sont des transistors PMOS.

8. Circuit selon la revendication 1 dans lequel lesdits moyens de circuit de commande comprennent une paire différentielle de premier (46) et deuxième (48) transistors MOS, ledit premier transistor MOS ayant une grille connectée audit moyen de niveau de tension et une première électrode de sortie connectée à ladite base dudit premier transistor bipolaire (30), ledit deuxième transistor MOS ayant une grille connectée à ladite sortie du circuit de référence (28).

9. Circuit selon la revendication 8 comprenant en outre un circuit en miroir de courant (50,52) ayant une première branche connectée à des deuxièmes électrodes de sortie desdits premier et deuxième transistors MOS et une deuxième branche connectée à une deuxième source de courant (54).
